(19) Europäisches Patentamt / European Patent Office / Office européen des brevets

(11) **EP 2 804 312 B1**

(12) **EUROPEAN PATENT SPECIFICATION**

(45) Date of publication and mention
of the grant of the patent:
**05.04.2017 Bulletin 2017/14**

(51) Int Cl.:
*H03F 1/02* (2006.01)     *H03F 1/32* (2006.01)
*H03F 1/56* (2006.01)

(21) Application number: **13191173.7**

(22) Date of filing: **31.10.2013**

(54) **Amplifier**

Verstärker

Amplificateur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.05.2013 JP 2013104288**

(43) Date of publication of application:
**19.11.2014 Bulletin 2014/47**

(73) Proprietor: **Kabushiki Kaisha Toshiba
Tokyo 105-8001 (JP)**

(72) Inventor: **Kuroda, Kenta
Minato-ku, Tokyo 105-8001 (JP)**

(74) Representative: **Moreland, David et al
Marks & Clerk LLP
Aurora
120 Bothwell Street
Glasgow G2 7JS (GB)**

(56) References cited:
**EP-A2- 2 378 670          WO-A1-2009/106494
KR-B1- 100 809 253     US-A- 4 442 416
US-A1- 2011 298 539**

EP 2 804 312 B1

Printed by Jouve, 75001 PARIS (FR)

**Description**

CROSS-REFERENCE TO RELATED APPLICATIONS

This application is based upon and claims the benefit of priority from the prior the Japanese Patent Application No.2013-104288, filed on May 16th, 2013.

FIELD

The present invention relates to an amplifier.

BACKGROUND

There has been conventionally used a high-frequency heating device using a microwave. The high-frequency heating device uses a high-power unmodulated signal.

However, a load connected to a microwave signal source may largely change in its impedance during heating or processing. When the microwave signal source is formed of an oscillator and a semiconductor amplifier, an abnormal oscillation may occur due to impedance mismatch between an amplification circuit and a load. When an abnormal oscillation occurs, a standing wave exceeding a design allowed range can occur, and an amplification device such as transistor configuring the amplifier can be broken.

Power and frequency signals against the radio law can be output due to an abnormal oscillation.

An abnormal oscillation of the amplifier needs to be monitored.

In terms of this, there is proposed a technique for extracting a microwave signal outside a desired frequency band by use of a filter and detecting an abnormal oscillation .

However, a matching circuit with a distribution constant is used in a semiconductor amplifier in many cases, and thus the matching circuit easily oscillates near the used frequency band, such as loop oscillation in a $\lambda/4$ combiner.

To the contrary, it is difficult to detect an abnormal oscillation occurring near the used frequency band in the technique using a filter.

US4442416 describes a variable impedance synthesis circuit for generating a selected impedance at a predetermined port.

BRIEF DESCRIPTION OF THE DRAWINGS

Fig. 1 is a diagram illustrating a structure of an amplifier; and
Fig. 2 is a diagram illustrating a structure of a variable of the amplifier.

DETAILED DESCRIPTION

An amplifier according to one embodiment will be described below in detail with reference to the drawing.

According to an embodiment there is provided an amplifier as recited in claim 1.

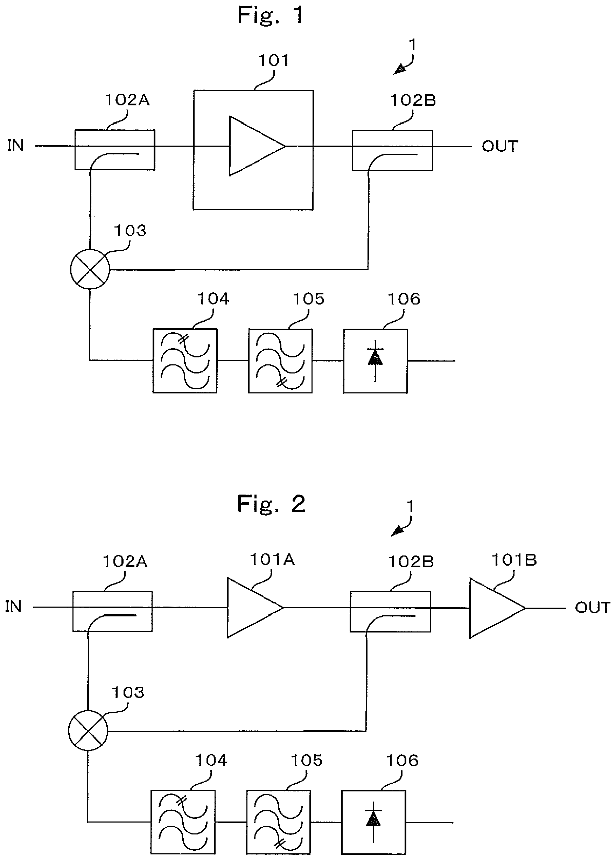

Fig. 1 is a diagram illustrating a structure of the amplifier 1 according to the present embodiment. As illustrated in Fig. 1, the amplifier 1 comprises a power amplifier 101 for amplifying an unmodulated high-frequency input signal IN, a first directional coupler 102A as the first branching device which is provided at an input terminal of the power amplifier 101 and extracts a signal, a second directional coupler 102B as the second branching device which is provided at an output terminal side of the power amplifier 101 and extracts a signal, a mixer for mixing a signal from the first directional coupler 102A and a signal from the second directional coupler 102B, a low-pass filter 104 for removing a frequency band component of the input signal IN from an output signal of the mixer 103, a high-pass filter 105 for removing a DC component from an output signal of the low-pass filter 104, and a wave detector 106 for extracting a signal.

The power amplifier 101 may be a multi--stage amplifier comprising a plurality of amplification devices.

The first branching device and the second branching device are not limited to a directional coupler. When a directional coupler is used for the first branching device and the second branching device, the directional coupler 102A and the second directional coupler 102B may use a well--known directional coupler.

The operations of the amplifier according to the present embodiment will be described below.

At first, when an abnormal oscillation does not occur, a voltage amplitude of an output signal of the first directional coupler 102A is expressed in Equation (1).

$$a_1 = A_1 \sin( \omega_1 t + \phi_1 ) \cdot \cdot \cdot (1)$$

A voltage amplitude of an output signal of the second directional coupler 102B is expressed in Equation (2).

$$a_2 = A_{21} \sin( \omega_1 t + \phi_{21} ) \cdot \cdot \cdot (2)$$

where A indicates a constant, $\omega$ indicates an input signal, t indicates a time and $\phi$ indicates an amplitude.

Therefore, when the mixer 103 is an ideal mixer, an output of the mixer 103 is expressed in Equation (3).

$$a_1 a_2 = \frac{A_1 A_{21}}{2} \{ \cos( \phi_1 - \phi_{21} ) - \cos( 2\omega_1 t + \phi_1 + \phi_{21} ) \} \quad \cdot \cdot \cdot (3)$$

A leak of an input signal to the output occurs in the actual mixer 103, but a frequency component of a second harmonic and a frequency component of an input signal IN are removed in the low-pass filter 104 so that the output of the low-pass filter 104 has only the DC term in Equation (3).

Therefore, the output of the high-pass filter 105 is 0 and the output of the wave detector 106 is also 0.

On the other hand, when an abnormal oscillation occurs, a voltage amplitude of an output signal of the first directional coupler 102A has at least one frequency component of other than the input signal as expressed in Equation (4).

$$a_2{}' = A_{21} \sin( \omega_1 t + \phi_{21} ) + A_{22} \sin( \omega_2 t + \phi_{22} ) \cdot \cdot \cdot (4)$$

Therefore, the output of the mixer 103 is expressed in Equation (5).

$$a_1 a_2{}' = \frac{A_1 A_{21}}{2} \{ \cos( \phi_1 - \phi_{21} ) - \cos( 2\omega_1 t + \phi_1 + \phi_{21} ) \}$$

$$+ \frac{A_1 A_{22}}{2} [ \cos\{ ( \omega_1 - \omega_2 )t + \phi_1 - \phi_{22} \} - \cos\{ ( \omega_1 + \omega_2 )t + \phi_1 + \phi_{22} \} ] \cdot \cdot \cdot (5)$$

When an abnormal oscillation occurs, the following terms are obtained, which are the outputs of a difference between and a sum of the frequency of other than the input signal and the frequency of the input signal.

$$\frac{A_1 A_{22}}{2} [ \cos\{ ( \omega_1 - \omega_2 )t + \phi_1 - \phi_{22} \} - \cos\{ ( \omega_1 + \omega_2 )t + \phi_1 + \phi_{22} \} ]$$

The difference and sum are not removed by the low-pasts filter 104 and the high-pass filter 105, and are detected by the wave detector 106.

Therefore, an abnormal oscillation occurring near the frequency band of the input signal can be detected.

Fig. 2 is a diagram illustrating a structure of a variant of the amplifier 1 according to the present embodiment. As illustrated in Fig. 2, the amplifier 1 comprises a first power amplifier 101A for amplifying an unmodulated high-frequency input signal IN, the first directional coupler 102A as the first branching device which is provided at an input terminal side of the first power amplifier 101A and extracts a signal, a second power amplifier 101B which is cascaded to the first power amplifier 101A and amplifies an output signal of the first power amplifier 101A, the second directional coupler 102B as the second branching device which is provided between an output terminal side of the first power amplifier 101A and an input terminal side of the second power amplifier 101B and extracts a signal, the mixer 103 for mixing a signal from the first directional coupler 102A and a signal from the second directional coupler 102B, the low-pass filter 104 for removing a frequency band component of the input signal IN from an output signal of the mixer 103, the high-pass filter 105 for removing a DC component from an output signal of the low-pass filter 104, and the wave detector 106 for extracting a signal.

The power amplifier 101 maybe a multi-stage amplifier comprising a plurality of amplification devices.

The first branching device and the second branching device are not limited to a directional coupler. When a directional coupler is used for the first branching device and the second branching device, the directional coupler 102A and the second directional coupler 102B may use a well-known directional coupler.

The second directional coupler 102B outputs an abnormal oscillation occurring between the first power amplifier 101A and the second amplifier 101B together with the input signal.

Therefore, the output of the second directional coupler is equal to that in Equation (3).

A component of the abnormal oscillation is extracted by the wave detector 106 through the above operations.

As described above, the amplifier 1 comprises the power amplifier 101 for amplifying an unmodulated high-frequency input signal IN, the first directional coupler 102A as the first branching device which is provided at the input terminal side of the power amplifier 101 and extracts a signal, the second directional coupler 102B as the second branching device which is provided at the output terminal side of the power amplifier 101 and extracts a frequency component of an abnormal oscillation together with a frequency component of the input signal, the mixer 103 for mixing a signal from the first directional coupler 102A and a signal from the second directional coupler 102B, the low-pass filter 104 for removing a frequency band component of the input signal IN from an output signal of the mixer 103, the high-pass filter 105 for removing a DC component from an output signal of the low-pass filter 104, and the wave detector 106 for extracting a signal.

While certain embodiments have been described, these embodiments have been presented by way of example only, and are not intended to limit the scope of the invention as claimed. Indeed, the novel methods and apparatuses described herein may be embodied in a variety of other forms; furthermore, various omissions, substitutions and changes in the form of the methods and systems described herein may be made without departing from the scope of the invention as claimed. The accompanying claims and their equivalents are indeed to cover such forms or modifications as would fall within the scope of the invention as claimed.

**Claims**

1.  An amplifier (1) comprising:

    a first power amplifier (101, 101A) configured to amplify an unmodulated high-frequency input generated by a microwave signal source;
    a first branching device (102A) which is provided at an input terminal of the first power amplifier (101, 101A) and is adapted to extract the input signal;
    a second branching device (102B) which is provided at an output terminal of the first power amplifier (101,101A) and is adapted to extract the output signal ;
    a mixer (103) configured to mix the signal from the first branching device (102A) and the signal from the second branching device (102B);
    **characterized in that** if an abnormal oscillation occurs near the frequency band of the input signal, a voltage amplitude of the output signal of the first branching device (102A) has at least one frequency component of other than the input signal; and **in that**
    the amplifier further comprises:

    a low-pass filter (104) configured to remove a frequency band component of the input signal from the output signal of the mixer (103);
    a high-pass filter (105) configured to remove a DC component from the output signal of the low-pass filter (104); and
    a wave detector (106)configured to extract a signal which has a frequency component with a frequency which is the difference between the frequency of the input signal and the frequency other than the frequency of the input signal; and a frequency component with a frequency that is the sum of the frequency of the input signal and the frequency other than the frequency of the input signal.

2.  The amplifier (1) according to claim 1, wherein the first power amplifier (101, 101A) is a multi-stage amplifier comprising a plurality of amplification devices.

3.  The amplifier (1) according to claim 2, wherein the first branching device (102A) and the second branching device (102B) are directional couplers.

**4.** The amplifier (1) according to claim 1, further comprising:

a second power amplifier (101B) which is cascaded to the first power amplifier (101A) and is adapted to amplify the output signal of the first power amplifier (101A); and wherein
the second branching device (102B) is provided between an output terminal of the first power amplifier (101A) and an input terminal of the second power amplifier (101B).

**5.** The amplifier according to claim 4, wherein the first branching device (102A) and the second branching device (102B) are directional couplers.

## Patentansprüche

**1.** Verstärker (1), umfassend:

einen ersten Leistungsverstärker (101, 101A), der dafür konfiguriert ist, einen durch eine Mikrowellen-Signalquelle erzeugten nicht modulierten Hochfrequenzeingang zu verstärken;
eine erste Verzweigungsvorrichtung (102A), die an einem Eingangsanschluss des ersten Leistungsverstärkers (101, 101A) bereitgestellt ist und dafür eingerichtet ist, das Eingangssignal zu extrahieren;
eine zweite Verzweigungsvorrichtung (102B), die an einem Ausgangsanschluss des ersten Leistungsverstärkers (101, 101A) bereitgestellt ist und dafür eingerichtet ist, das Ausgangssignal zu extrahieren;
einen Mischer (103), der dafür konfiguriert ist, das Signal von der ersten Verzweigungsvorrichtung (102A) und das Signal von der zweiten Verzweigungsvorrichtung (102B) zu mischen;

**dadurch gekennzeichnet, dass**:

wenn eine anormale Schwingung nahe dem Frequenzband des Eingangssignals auftritt, eine Spannungsamplitude des Ausgangssignals der ersten Verzweigungsvorrichtung (102A) mindestens eine Frequenzkomponente eines anderen als des Eingangssignals hat; und dadurch, dass der Verstärker ferner umfasst:
ein Tiefpassfilter (104), das dafür konfiguriert ist, eine Frequenzbandkomponente des Eingangssignals aus dem Ausgangssignal des Mischers (103) zu entfernen;
ein Hochpassfilter (105), das dafür konfiguriert ist, eine Gleichspannungskomponente aus dem Ausgangssignal des Tiefpassfilters (104) zu entfernen; und
einen Wellendetektor (106), der dafür konfiguriert ist, ein Signal zu extrahieren, das eine Frequenzkomponente mit einer Frequenz, welche die Differenz zwischen der Frequenz des Eingangssignals und der anderen Frequenz als der des Eingangssignals ist, und eine Frequenzkomponente mit einer Frequenz, welche die Summe der Frequenz des Eingangssignals und der anderen Frequenz als der des Eingangssignals ist, hat.

**2.** Verstärker (1) nach Anspruch 1, worin der erste Leistungsverstärker (101, 101A) ein mehrstufiger Verstärker ist, der eine Vielzahl von Verstärkungsvornchtungen umfasst.

**3.** Verstärker (1) nach Anspruch 2, worin die erste Verzweigungsvorrichtung (102A) und die zweite Verzweigungsvorrichtung (102B) Richtkoppler sind.

**4.** Verstärker (1) nach Anspruch 1, ferner umfassend:

einen zweiten Leistungsverstärker (101B), der mit dem ersten Leistungsverstärker (101A) in Kaskade geschaltet ist und dafür eingerichtet ist, das Ausgangssignal des ersten Leistungsverstärkers (101A) zu verstärken; und worin
die zweite Verzweigungsvorrichtung (102B) zwischen einem Ausgangsanschluss des ersten Leistungsverstärkers (101A) und einem Eingangsanschluss des zweiten Leistungsverstärkers (101B) bereitgestellt ist.

**5.** Verstärker (1) nach Anspruch 4, worin die erste Verzweigungsvorrichtung (102A) und die zweite Verzweigungsvorrichtung (102B) Richtkoppler sind.

**Revendications**

1. Amplificateur (1) comprenant :

   un premier amplificateur de puissance (101, 101A) configuré de manière à amplifier une entrée haute fréquence non modulée générée par une source de signal hyperfréquence ;
   un premier dispositif de dérivation (102A) qui est fourni au niveau d'une borne d'entrée du premier amplificateur de puissance (101, 101A) et qui est apte à extraire le signal d'entrée ;
   un second dispositif de dérivation (102B) qui est fourni au niveau d'une borne de sortie du premier amplificateur de puissance (101, 101A) et qui est apte à extraire le signal de sortie ;
   un mélangeur (103) configuré de manière à mélanger le signal provenant du premier dispositif de dérivation (102A) et le signal provenant du second dispositif de dérivation (102B) ;

   **caractérisé en ce que**

   si une oscillation anormale se produit à proximité de la bande de fréquence du signal d'entrée, une amplitude de tension du signal de sortie du premier dispositif de dérivation (102A) présente au moins une composante de fréquence distincte de celle du signal d'entrée ; et **en ce que** l'amplificateur comprend en outre :

   un filtre passe-bas (104) configuré de manière à supprimer, du signal de sortie du mélangeur (103), une composante de bande de fréquence du signal d'entrée;
   un filtre passe-haut (105) configuré de manière à supprimer une composante de courant continu du signal de sortie du filtre passe-bas (104) ; et
   un détecteur d'ondes (106) configuré de manière à extraire un signal qui présente une composante de fréquence avec une fréquence qui correspond à la différence entre la fréquence du signal d'entrée et la fréquence distincte de la fréquence du signal d'entrée ; et une composante de fréquence avec une fréquence qui correspond à la somme de la fréquence du signal d'entrée et de la fréquence distincte de la fréquence du signal d'entrée.

2. Amplificateur (1) selon la revendication 1, dans lequel le premier amplificateur de puissance (101, 101A) est un amplificateur à plusieurs étages comprenant une pluralité de dispositifs d'amplification.

3. Amplificateur (1) selon la revendication 2, dans lequel le premier dispositif de dérivation (102A) et le second dispositif de dérivation (102B) sont des coupleurs directionnels.

4. Amplificateur (1) selon la revendication 1, comprenant en outre :

   un second amplificateur de puissance (101B) qui est monté en cascade sur le premier amplificateur de puissance (101A), et qui est apte à amplifier le signal de sortie du premier amplificateur de puissance (101A) ; et dans lequel le second dispositif de dérivation (102B) est fourni entre une borne de sortie du premier amplificateur de puissance (101A) et une borne d'entrée du second amplificateur de puissance (101B).

5. Amplificateur selon la revendication 4, dans laquelle le premier dispositif de dérivation (102A) et le second dispositif de dérivation (102B) sont des coupleurs directionnels.

Fig. 1

Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013104288 A

- US 4442416 A